# EUROPEAN PATENT APPLICATION

(11) **EP 4 709 081 A1**
(43) Date of publication of application: **11.03.2026**
(21) Application number: 25168150.8
(22) Date of filing: 03.04.2025
(51) Int. Cl.: H10D 30/01, H10D 30/66, H10D 62/10, H10D 64/00, H10D 64/23

(54) **SEMICONDUCTOR DEVICE HAVING TRENCH TERMINATION STRUCTURE AND METHOD OF MANUFACTURING**

(30) Priority: 30.08.2024 US 202418820773
(71) Applicant: Semiconductor Components Industries, LLC, Scottsdale, AZ 85250 (US)
(72) Inventor: BURKE, Peter A., Portland, OR 97212 (US); VENKATRAMAN, Prasad, Gilbert, AZ 85295 (US)
(74) Representative: Manitz Finsterwald Patent- und Rechtsanwaltspartnerschaft mbB

(57) **Abstract**

A semiconductor device includes a first termination trench at a first edge region and a second termination trench at a second edge region. A first active trench extends from the first termination trench towards the second termination trench and terminates with a first tip region separated from the second termination trench by the termination mesa region. A second active trench extends from the second termination trench towards the first termination trench and terminates with a second tip region separated from the first termination trench by the termination mesa region. A first gate contact trench is connected to the first termination trench within the first edge region. A coupling trench is at a third edge region and is connected to the second termination trench, The coupling trench includes a corner portion that couples the coupling trench to the first gate contact trench.

## Description

### Cross-Reference to Related Applications

Not applicable.

### Technical Field

The present disclosure relates, in general, to electronics and, more particularly, to semiconductor device structures and methods of forming semiconductor devices.

### Background

As semiconductor devices, such as shield gate trench metal oxide field effect transistor (MOSFET) devices, are reduced in size, it has become difficult to integrate additional shield contact structures within an MOSFET cell topography to achieve reduced shield electrode resistance without detrimentally impacting other MOSFET characteristics. A low shield resistance is desired to provide a MOSFET with low gate bounce, good unclamped inductive switching (UIS) performance, and higher operating efficiency. For proper device functioning, structures and methods are desired that facilitate reduced shield resistance without adversely affecting the breakdown voltage of the device.

### Brief Description of the Drawings

FIG. 1 illustrates a partial top plan view of an example cell topography of a semiconductor device in accordance with the present description;
FIG. 2 illustrates an enlarged partial top plan view of portion 2A referenced in FIG. 1 in accordance with the present description;
FIG. 3 illustrates an enlarged partial top plan view of portion 3A referenced in FIG. 1 in accordance with the present description;
FIG. 4 illustrates a partial cross-sectional view of a portion of the semiconductor device of the example cell topography taken along reference line 4A-4A of FIG. 2;
FIG. 5 illustrates a partial cross-sectional view of a portion of the semiconductor device of the example cell topography taken along reference line 5A-5A of FIG. 3;
FIG. 6 illustrates a partial top plan view of an example cell topography of a semiconductor device in accordance with the present description;
FIG. 7 illustrates a partial top plan view of an example cell topography of a semiconductor device in accordance with the present description;
FIG. 8 illustrates a partial cross-sectional view of an example shield contact trench taken along reference line 8A-8A of FIG. 6;
FIG. 9 illustrates a partial cross-sectional view of an example shield contact trench taken along reference line 9A-9A of FIG. 7;
FIG. 10 illustrates a partial top plan view of an example cell topography of a semiconductor device in accordance with the present description;
FIG. 11 illustrates a partial top plan view of an example cell topography of a semiconductor device in accordance with the present description;
FIG. 12 illustrates a partial top plan view of an example cell topography of a semiconductor device in accordance with the present description; and
FIG. 13 illustrates a partial cross-sectional view of an example semiconductor device in accordance with the present description.

The following discussion provides various examples of semiconductor devices and methods of manufacturing semiconductor devices. Such examples are non-limiting, and the scope of the appended claims should not be limited to the particular examples disclosed. In the following discussion, the terms "example" and "e.g." are non-limiting.

For simplicity and clarity of the illustration, elements in the figures are not necessarily drawn to scale, and the same reference numbers in different figures denote the same elements. Additionally, descriptions and details of well-known steps and elements are omitted for simplicity of the description.

For clarity of the drawings, certain regions of device structures, such as doped regions or dielectric regions, trenches, or contacts may be illustrated as having generally straight-line edges and precise angular corners. However, those skilled in the art understand that, due to the diffusion and activation of dopants or formation of layers, the edges of such regions generally may not be straight lines and that the corners may not be precise angles.

Although the semiconductor devices are explained herein as certain N-type conductivity regions and certain P-type conductivity regions, a person of ordinary skill in the art understands that the conductivity types can be reversed and are also possible in accordance with the present description, considering any necessary polarity reversal of voltages, inversion of transistor type and/or current direction, etc.

In addition, the terminology used herein is for the purpose of describing particular examples only and is not intended to be limiting of the disclosure. As used herein, the singular forms are intended to include the plural forms as well, unless the context clearly indicates otherwise.

As used herein, "current-carrying electrode" means an element of a device that carries current through the device, such as a source or a drain of an MOS transistor, an emitter or a collector of a bipolar transistor, or a cathode or anode of a diode, and a "control electrode" means an element of the device that controls current through the device, such as a gate of a MOS transistor or a base of a bipolar transistor.

The term "major surface" when used in conjunction with a semiconductor region, wafer, or substrate means the surface of the semiconductor region, wafer, or substrate that forms an interface with another material, such as a dielectric, an insulator, a conductor, or a polycrystalline semiconductor. The major surface can have a topography that changes in the x, y and z directions.

In addition, structures of the present description can embody either a cellular-base design (in which the body regions are a plurality of distinct and separate cellular or stripe regions) or a single-base design (in which the body region is a single region formed in an elongated pattern, typically in a serpentine pattern or a central portion with connected appendages). However, one embodiment of the present description will be described as a cellular base design throughout the description for ease of understanding. It is understood that the present description encompasses both a cellular-base design and a single-base design.

The terms "comprises", "comprising", "includes", "including", "has", "have" and/or "having" when used in this description, are open ended terms that specify the presence of stated features, numbers, steps, operations, elements, and/or components, but do not preclude the presence or addition of one or more other features, numbers, steps, operations, elements, components, and/or groups thereof.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

Although the terms "first", "second", etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

It will be appreciated by one skilled in the art that words, "during", "while", and "when" as used herein related to circuit operation are not exact terms that mean an action takes place instantly upon an initiating action but that there may be some small but reasonable delay, such as propagation delay, between the reaction that is initiated by the initial action. Additionally, the term "while" means a certain action occurs at least within some portion of a duration of the initiating action.

The use of word "about", "approximately", or "substantially" means a value of an element is expected to be close to a state value or position. However, as is well known in the art there are always minor variances preventing values or positions from being exactly stated.

Unless specified otherwise, as used herein, the word "over" or "on" includes orientations, placements, or relations where the specified elements can be in direct or indirect physical contact.

Unless specified otherwise, as used herein, the word "overlapping" includes orientations, placements, or relations where the specified elements can at least partly or wholly coincide or align in the same or different planes.

It is further understood that the examples illustrated and described hereinafter suitably may have examples and/or may be practiced in the absence of any element that is not specifically disclosed herein.

### Description

Insulated gate field effect transistors (IGFETs), such as metal oxide semiconductor field effect transistors (MOSFETs), have been used in many power switching applications, such as DC-DC converters. In a typical MOSFET, a gate electrode provides turn-on and turn-off control with the application of an appropriate gate voltage. By way of example, in an N-type enhancement mode MOSFET, turn-on occurs when a conductive N-type inversion layer (i.e., channel region) is formed in a P-type body region in response to the application of a positive gate voltage, which exceeds an inherent threshold voltage. The inversion layer connects N-type source regions to N-type drain regions and allows for majority carrier conduction between these regions.

There is a class of MOSFET devices referred as trench MOSFET devices. In a trench MOSFET device, a gate electrode is formed in a trench that extends downward (e.g., vertically downward) from a major surface of a semiconductor material such as silicon. Current flow in a trench MOSFET device is primarily vertical (e.g., in an N-type conductivity doped drift region) and, as a result, device cells can be more densely packed. Packing several device cells together increases the current carrying capability and reduces on-resistance of the device.

A device cell may, for example, include a trench that contains the gate electrode and an adjoining semiconductor mesa that contains the drain, drift region, source, body, and channel regions of the device. An example trench MOSFET device may include an array of hundreds or thousands of device cells (each including a trench and an adjoining mesa). A device cell may be referred to herein as a trench-mesa cell because each device cell geometrically includes a trench structure and a mesa structure (or two half mesas).

Trench MOSFET devices can further include a shield electrode formed below the gate electrode in the trench and insulated from the gate electrode by one or more dielectrics. In some examples, the shield electrode can be coupled to the source electrode of the device. Shield electrodes have several advantages including facilitating higher dopant concentrations in the drift region and provide a shielding effect that can improve switching capability and other performance parameters. However, the shield electrode can require low shield resistance to provide, among other things, low gate bounce, good unclamped inductive switching (UIS) performance, and higher efficiencies.

In some applications, such as motor drive applications, device ruggedness, which includes the ability to withstand shorter current bursts with higher currents, has become increasingly important. Because high shield resistance at the device edge results in high current UIS, providing structures and methods with low shield resistance at the device edge are needed to meet increasingly stringent performance requirements.

Current trench MOSFET termination structures for medium voltage devices (for example, voltages between about 30 volts to about 100 volts) have shown improved breakdown voltage (BV_{DSS}) performance but have not supported low shield resistance at the device edge without other structural changes. Such structural changes can include an additional shield feed, which can be as wide as 30 microns and must completely surround the entire device edge. Unfortunately, this approach results in a non-preferred increase in die size or the degradation of other device parameters.

One type of termination structure for a trench MOSFET device can be referred to as a gate-terminated trench (GTT) structure that uses connected trench termination design, which can help reduce the effects of electric field build-up under a blocking or reverse bias condition. Some GTT designs have exhibited improvements in supporting high-current UIS but also exhibit an unacceptable degradation in BV_{DSS} in at least medium voltage devices (for example, voltages between about 30 to about 100 volts). Thus, structures and methods are needed to address this degradation in BV_{DSS}.

In general, the present examples relate to semiconductor device structures and methods of making semiconductor devices, such as shielded-gate trench MOSFET devices, having improved manufacturability and performance. In some examples, structures and methods are described that address the BV_{DSS} performance issue in GTT structures that use an arch-termination design. Examples include a GTT type cell topography that have interleaved or offset comb active trenches, an arch-termination design, and a coupling trench. The coupling trench connects to one side of the cell topography and includes a wrap-around top trench that connects to a gate contact trench at an opposite side of the cell topography. The coupling trench can also form an additional termination trench that facilitates design flexibility. In some examples, gate connections can be provided on opposing sides of the cell topography to reduce gate resistance.

In some examples, shield electrode connections are also facilitated on opposing edges or sides of the cell topography, which reduces shield resistance. In some examples, for a given cell topography length, the present structures reduce shield resistance by approximately one half. Compared to previous cell topographies, the shield electrode connections are provided without interrupting the connections between the active gate trenches and the gate electrode connections, which are outside of the area of the topography where source metal contact is made. In addition, the present description provides shield electrode contacts inside the area of the topography where source metal contact is made. Examples are also described that provide additional shield contacts within the cell topography to further improve shield resistance performance. The cell topography also facilitates gate connections from one side or an opposing side or both. In some examples, a gate silicide structure can be used to offset any increase in gate resistance.

In an example, semiconductor device includes a region of semiconductor material, which includes a top side, an active mesa region, a termination mesa region, an intersection mesa region, a first edge region at the top side, a second edge region at the top side opposite to the first edge region, and a third edge region at the top side extending between the first edge region and the second edge region. A first termination trench is within the first edge region and a second termination trench is within the second edge region and is coupled to the first termination trench. A first active trench extends from the first termination trench towards the second termination trench and terminates with a first tip region separated from the second termination trench by the termination mesa region. A second active trench extends from the second termination trench towards the first termination trench, is separated from the first active trench by the active mesa region and terminates with a second tip region separated from the first termination trench by the termination mesa region. A first gate contact trench is coupled to the first termination trench within the first edge region. A coupling trench is within the third edge region coupled to the second termination trench and includes a corner portion that couples the coupling trench to the first gate contact trench. The intersection mesa region separates the corner portion from the first termination trench. A shield electrode is within the coupling trench and a shield dielectric is within the coupling trench and insulates the shield electrode from the region of semiconductor material. A gate electrode is within the coupling trench and a gate dielectric is within the coupling trench and insulates the gate electrode from the region of semiconductor material. An inter-electrode dielectric insulates the gate electrode from the shield electrode.

In an example, a semiconductor device includes a region of semiconductor material, which includes a top side, an active mesa region, a termination mesa region, an intersection mesa region, a first edge region at the top side, a second edge region at the top side opposite to the first edge region, and a third edge region at the top side extending between the first edge region and the second edge region. A first termination trench is within the first edge region and a second termination trench within the second edge region and is coupled to the first termination trench. First active trenches extend from the first termination trench towards the second termination trench and terminate with first tip regions that are separated from the second termination trench by the termination mesa region. Second active trenches extend from the second termination trench towards the first termination trench, are interleaved with the first active trenches, are separated from the first active trenches by the active mesa region and terminate with second tip regions that are separated from the first termination trench by the termination mesa region. A first gate contact trench is coupled to the first termination trench within the first edge region. A coupling trench is within the third edge region and is coupled to the second termination trench. The coupling trench includes a corner portion that couples the coupling trench to the first gate contact trench. The corner portion is separated from the first termination trench by the intersection mesa region. A shield electrode is in the coupling trench and a shield dielectric is in the coupling trench and insulates the shield electrode from the region of semiconductor material. A gate electrode is in the coupling trench and includes a first side adjacent to the termination mesa region and a second side opposite to the first side. A gate dielectric is in the coupling trench and insulates the first side of the gate electrode from the intersection mesa region. The shield dielectric insulates the second side of the gate electrode from the region of semiconductor material. An inter-electrode dielectric insulates the gate electrode from the shield electrode.

In an example, a method of manufacturing a semiconductor device can include providing a region of semiconductor material, providing a first termination trench within the region of semiconductor material and providing a second termination trench within the region of semiconductor and coupled to the first termination trench, wherein the first termination trench and the second termination trench define an active area. The method includes providing active trenches within the active area and providing a coupling trench within the region of semiconductor material and external to the active area. The method includes providing a shield conductor within the coupling trench, the active trenches, the first termination trench, and the second termination trench. The method includes providing a gate conductor within the coupling trench, the active trenches, the first termination trench; and the second termination trench. The method includes providing a shield contact trench coupled to the first termination trench and providing a shield contact via within the shield contact trench, external to the active area, and coupled to the shield conductor. The method includes providing a gate contact trench coupled to the first termination trench and providing a gate contact via within the gate contact trench and coupled to the gate conductor. The gate conductor is a continuous and uninterrupted conductor within the active area and the coupling trench couples the active area to the gate contact trench. In another example, the method includes providing the active area devoid of any shield contact vias.

In some examples, the semiconductor device includes a second gate contact trench coupled to the second termination trench within the second edge region and a first shield contact trench coupled to the first termination trench within the first edge region. In some examples, the first shield contact trench is parallel to the first gate contact trench. In some examples, the first shield contact trench is perpendicular to the first gate contact trench and intersects the first gate contact trench. In some examples, the second gate contact trench is laterally offset with respect to the first gate contact trench in a top plan view.

Other examples are included in the present disclosure. Such examples may be found in the figures, in the claims, or in the description of the present disclosure.

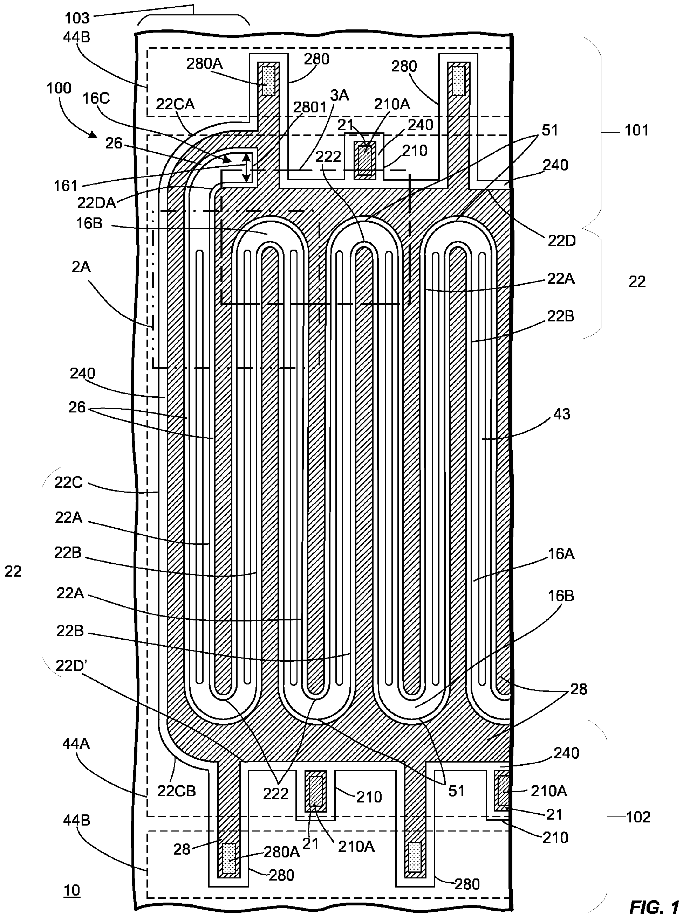

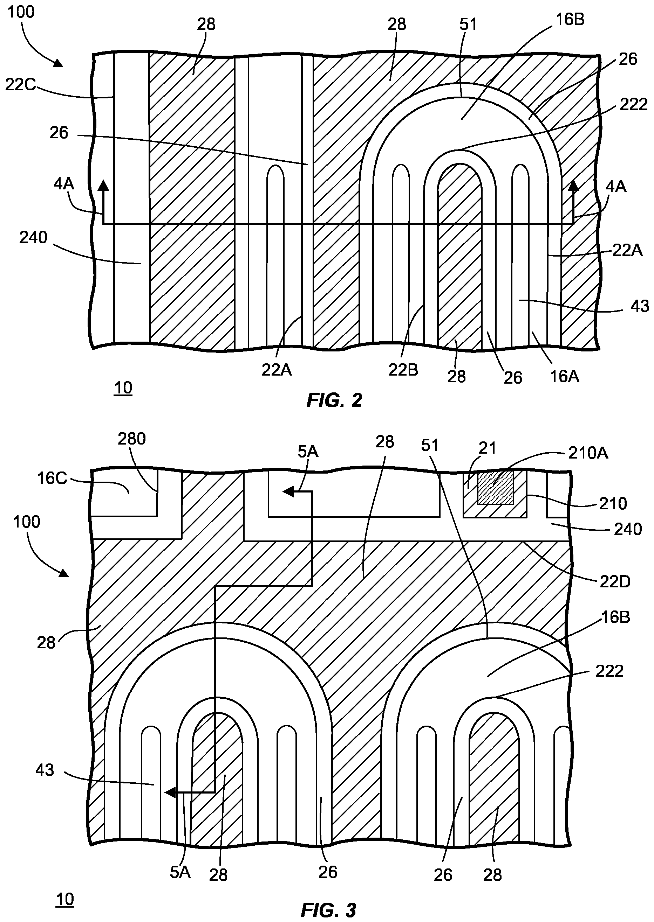

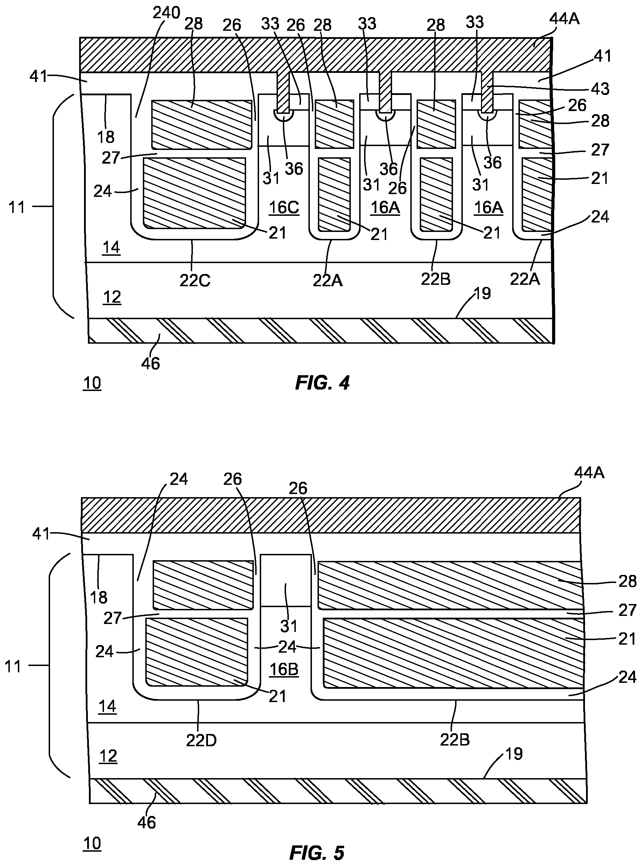

FIG. 1 illustrates a partial top plan view of a cell topography 100 of a semiconductor device 10 in accordance with the present description. FIG. 2 illustrates an enlarged partial top plan view of portion 2A of cell topography 100 referenced in FIG. 1 and FIG. 3 illustrates an enlarged partial top plan view of portion 3A of cell topography 100 referenced in FIG. 1. FIG. 4 illustrates a partial cross-sectional view of a portion of semiconductor device 10 taken along reference line 4A-4A of FIG. 2 and FIG. 5 illustrates a partial cross-sectional view of another portion of semiconductor device 10 taken along reference line 5A-5A of FIG. 3. Reference is made to FIGS. 1-5 in the following description.

Cell topography 100 can also be referred to as a device layout, a GTT cell topography, or cell layout, and semiconductor device 10 can also be referred to as a semiconductor component, an electronic device structure, or an electronic component. In some examples, cell topography 100 is suitable for medium voltage devices, such as 30 volt to 100 volt shielded-gate trench MOSFET devices. However, the structures and method described herein are relevant to shielded-gate devices where low shield resistance is needed. In the top plan view of FIG. 1, semiconductor device 10 conductors 44A and 44B are illustrated in phantom to better illustrate the structure below. The cross-hatching in FIGS. 1, 2, and 3 illustrates a top view of gate conductor 28. In some examples, gate conductor 28 in cell topography 100 is a continuous conductor without breaks or interruptions, which reduces gate resistance and simplifies the placement of gate contact structures in cell topography 100, such as conductor 44B. In the present example, cell topography comprises edge region 101 at top side 18 (see e.g., FIGS. 4 and 5) of semiconductor device 10, edge region 102 opposite to edge region 101 at top side 18, and edge region 103 extending between edge region 101 and edge region 102. Edge region 101 can be an example of a first edge region or upper edge region, edge region 102 can be an example of a second edge region or lower edge region, and edge region 103 can be an example of third edge region or outer edge region.

In accordance with the present description, semiconductor device 10 is configured to facilitate multiple shield contact trenches 210 to provide reduced shield electrode resistance while maintaining breakdown voltage (BV_{DSS}) with the addition of a coupling trench 22C comprising a corner portion 22CA that is coupled to a gate contact trench 280 within edge region 101 of cell topography 100. Coupling trench 22C is also configured to reduce shield resistance at an edge region of semiconductor device 10 by provided an additional shield electrode runner. Semiconductor device 10 is shown as an N-channel MOSFET device, but it is understood that the structures and methods of the present description can be used for other types of semiconductor devices, such as insulated gate bipolar transistor (IGBT) devices. In other examples, semiconductor device 10 can be a P-channel MOSFET device by reversing the conductivity types of the various regions described hereinafter.

Cell topography 100 is illustrated as a partial-cell and a full cell can be provided by continuing the cell to the right of FIG. 1 for a desired number of active trenches. In some examples, a second coupling trench can be added at the right side of cell topography 100. The second coupling trench can be a mirror image of coupling trench 22C or can be vertically flipped so that the corner portion (e.g., corner portion 22CA) can be proximate to bottom side of cell topography 100. In one example, the partial cell of FIG. 1 can duplicated and flipped 180 degrees and combined with the illustrated partial cell to provide a full cell. As known by those of ordinary skill in the art, cell topography 100 is duplicated multiple times as part of a photolithographic reticle set or a mask set to provide a desired cell density for semiconductor device 10. In some examples, cell topography is provided on or as part of semiconductor device 10 using photolithographic patterning techniques, such as patterned photoresist and etching processes.

In the present example, cell topography 100 comprises trench region 22, which can include active trenches 22A, active trenches 22B, one or more coupling trenches 22C, top termination trench 22D, and bottom termination trench 22D'. In some examples, trench region 22 is a continuous region where active trenches 22A, active trenches 22B, coupling trench 22C, top termination trench 22D, and bottom termination trench 22D' are all connected as a continuous trench structure. In the present example, top termination trench 22D is within edge region 101, bottom termination trench 22D' is within edge region 102, and coupling trench 22C is within edge region 103. Active trenches 22A are laterally separated from active trenches 22B by active mesa region 16A, and tip regions 222 of active trenches 22A and active trenches 22B are separated from top termination trench 22D and bottom termination trench 22D' respectively by termination mesa region 16B.

In some examples, trench region 22 can be provided within region of semiconductor material 11 (see FIGS. 4 and 5) extending from top side 18 using conventional photopatterning and etch techniques. When region of semiconductor material 11 comprises silicon, trench region 22 can be provided using a fluorine etch chemistry or similar chemistries as known to one of ordinary skill in the art. In some examples, active trenches 22A and active trenches 22B, and coupling trench 22C can have a width in a range from about 200 nanometers to about 2 microns. In some examples, the width is about 600 nanometers. In some examples, coupling trench 22C can have width in a range from about 300 nanometers to about 3 microns. In some examples, the width of coupling trench 22C is greater than the width of active trenches 22A and active trenches 22B.

Termination trench 22D can be an example of a first termination trench and bottom termination trench 22D' can be an example of a second termination trench. Active trench 22A can be an example of a first active trench extending from the first termination trench towards the second termination trench. Active trench 22B can be an example of a second active trench extending from the second termination trench toward the first termination trench, separated from the first active trench by active mesa region 16A.

In some examples, active trenches 22A branch or extend in a downward direction from top termination trench 22D, and active trenches 22B branch or extend in an upward direction from bottom termination trench 22D'. It is understood that the terms downward and upward are used to help in the present description, but other terms describing orientation, such as first and second, or left and right (for example, if cell topography 100 is rotated 90 degrees) can be used.

In some examples, active trenches 22A and active trenches 22B extend in opposite directions with respect to each other and are provided in an interleaved configuration where active trenches 22A are coupled together through top termination trench 22D and active trenches 22B are coupled together through bottom termination trench 22D'. In some examples, the upper part of cell topography 100 is offset with respect to the lower part of cell topography 100. For example, gate contact trenches 280 and shield contact trenches 210 at the top side of cell topography 100 are not aligned with gate contact trenches 280 and shield contact trenches 210 at the bottom side of cell topography 100. In other examples, the upper part of cell topography 100 is not offset with respect to the lower part of cell topography 100. In some examples, an active trench 22A can be interposed between a pair of active trenches 22B or an active trench 22B can be interposed between a pair of active trenches 22A. In the present example, one of active trenches 22A is provided as the left-most active trench or outer left active trench. In some examples, an active trench 22B is provided as the right-most active trench or outer right active trench for cell topography 100. In the present example, active mesa regions 16A separate active trenches 22A and active trenches 22B.

In some examples, top termination trench 22D and bottom termination trench 22D' comprise arched termination structures 51 proximate to tip regions 222 of active trenches 22A and active trenches 22B. In some examples, active trenches 22A and 22B can comprise or be referred to as shielded-gate trench regions or elongate striped trench regions, and top termination trench region 22D and bottom termination region 22D' can comprise or be referred to as termination trench regions, termination regions, or GTT regions. In present example, arched termination structures 51 comprise concave structures or inward rounded arches, and tip regions 222 comprise convex structures or outward rounded arches. In the present example, termination mesa regions 16B separate tip regions 222 from arched termination structures 51. In some examples, arched termination structures 51 in top termination trench 22D are laterally offset with the respect to arched termination structures 51 in bottom termination trench 22D' in the top plan view of FIG. 1.

As illustrated in FIGS. 1, 2, 3, 4, and 5, active trenches 22A and active trenches 22B comprise shield dielectric 24, shield electrodes 21, inter-electrode dielectric 27, gate dielectric 26, upper trench dielectric 240, and gate electrodes 28. Also, termination trenches 22D and termination trenches 22D' comprise shield dielectric 24, shield electrodes 21, inter-electrode dielectric 27, upper trench dielectric 240, and gate electrode 28. In some examples, termination trenches 22D and termination trenches 22D' comprise gate dielectric 26 adjacent to sides of termination trenches 22D and termination trenches 22D' that are proximate to active trenches 22A and 22B. In the present example, termination trenches 22D and 22D' comprise upper trench dielectric 240 along the outer edges of cell topography 100 including gate contact trenches 280 and shield contact trenches 210. In accordance with the present description, upper trench dielectric 240 is thicker than shield dielectric 24. Upper trench dielectric 240 is configured to provide lower gate to drain capacitance.

Cell topography 100 further comprises gate contact trenches 280 and shield contact trenches 210 located on the top side and the bottom side of cell topography 100. In the present example, gate contact trenches 280 and shield contact trenches are generally parallel with each other and do not intersect. In this way, a lower shield resistance can be provided compared to previous devices that used a single shield contact trench in the center portion of the topography. Gate contact trenches 280 are coupled to gate electrodes 28 through gate contact vias 280A and shield contact trenches 210 are coupled to shield electrodes 21 through shield contact vias 210A. More particularly, the gate contact vias 280A and the shield contact vias 210A couple the gate electrodes 28 and shield electrodes 21 to conductor 44B and conductor 44B respectively. In accordance with the present description, gate electrode 28 is continuous from active trenches 22A, active trenches 22B, and termination trenches 22D and 22D' to gate contact trenches 280 on the same side edge of cell topography. Also, shield electrode 21 is continuous with shield contact trenches 210 going under gate electrode 28 in termination trenches 22D and 22D'. Although gate electrodes 28 and shield electrodes 28 are referred to as plural, it is understood that gate electrodes 28 and shield electrodes 21 in semiconductor device 10 can each be a single continuous conductive structure without breaks. In the present example, gate contact trenches 280 have a longer length than shield contact trenches 210 so that conductor 44A can be conveniently coupled to both shield contact trenches 210 and source regions 33 of semiconductor device 10 through conductive vias 43. Also, conductor 44B can be conveniently coupled to gate contact trenches 280 at the top side of cell topography 100 above and at the bottom side below conductor 44A in the top plan view.

In some examples, the internal portion or active area of cell topography 100 between termination trench 22D and termination trench 22D' can be devoid of shield contact vias 210A. More particularly, in some examples the only shield contact trenches 210 or shield contact vias 210A in cell topography 100 and semiconductor device 10 are those shield contact trenches 210 or shield contact vias 210A that are external to or outside the boundary defined by top termination trench 22D and bottom termination trench 22D'. In this way, gate electrode 28 can be a continuous or uninterrupted structure internal to or inside the boundary defined by top termination trench 22D and bottom termination trench 22D'. An example of this configuration is illustrated in FIG. 1. In some examples, this reduces any impact on gate resistance. As will be described later, in other examples, additional shield contact vias 210A can be placed in the active area between termination trench 22D and termination trench 22D' or within coupling trench 22C.

Termination trench 22D comprises a corner portion 22DA that is proximate to corner portion 22CA of coupling trench 22C and is separated by an intersecting mesa region 16C. The inside edge of corner portion 22DA where it couples to gate contact trench 280 is spaced apart from the outside edge of corner portion 22DA by a distance 161. It was found through experimentation that distance 161 is a design variable that affects BV_{DSS} of semiconductor device 10. In some examples, distance 161 is greater than 600 nanometers. In some examples, distance 161 is greater than 700 nanometers. In some examples, distance 161 is greater than 800 nanometers. In some examples, distance 161 is greater than 900 nanometers. In some examples, distance 161 is greater than 1000 nanometers. In some examples, distance 161 is in a range from about 800 nanometers to about 1000 nanometers. In some examples, the width of intersecting trench region 16C is different from and typically wider than the width of active mesa region 16A. In some examples, sidewall 2801 of gate contact trench 280 that extends between the outside edge of termination trench 22D and the inside edge of coupling trench 22C comprises a straight, linear, or non-curved shape in the top plan view.

In accordance with the present description and with reference to FIG. 1 and FIG. 4, coupling trench 22C provides an additional shield electrode 21 portion or runner at the outer edge of cell topography 100. In this way, coupling trench 22C is configured to reduce shield resistance at the outer edge of semiconductor device 10, which was found through experimentation to improve device performance including improving high current UIS capability while maintaining good BV_{DSS} performance. In addition, it was found through experimentation that cell topography 100 provides semiconductor device 10 with a lower resistance in packaged form and this together with the improved high current UIS capability improves performance in motor control applications including motor control applications. Further, corner portion 22CA is configured to maintain charge balance for the termination region of semiconductor device 10, which helps maintain or improve BV_{DSS} performance.

With reference to FIGS. 4 and 5, in some examples, semiconductor device 10 comprises a region of semiconductor material 11, which may also comprise or be referred to as a body of semiconductor material, a semiconductor work piece, a semiconductor region, or a semiconductor material. In some examples, region of semiconductor material 11 comprises silicon. In other examples, region of semiconductor material 11 or portions thereof can comprise other semiconductor materials, including, but not limited to silicon-germanium, silicon-germanium-carbon, carbon-doped silicon, silicon carbide, gallium nitride, or other related or equivalent materials as known to one of ordinary skill in the art.

As illustrated in FIGS. 4 and 5, in some examples region of semiconductor material 11 can comprise a substrate 12, such as an N-type silicon substrate, and a semiconductor region 14 adjacent to substrate 12. Substrate 12 can also be referred to as a semiconductor substrate or starting substrate and semiconductor region 14 can also be referred to as a semiconductor layer(s) or an extended drain region. In some examples, substrate 12 has a resistivity ranging from about 0.0005 ohm-cm to about 0.005 ohm-cm. By way of example, substrate 12 can be doped with phosphorous, arsenic, or antimony. In the example illustrated, substrate 12 provides a drain region, drain contact, or a first current carrying contact for semiconductor device 10. Region of semiconductor material 11 comprises a major surface 18 and a major surface 19 opposite to major surface 18. Major surface 18 can also be referred to as a top side or an upper side and major surface 19 can also be referred to as a back side or a lower side.

In some examples, semiconductor region 14 can be formed using semiconductor epitaxial growth techniques. Alternatively, semiconductor region 14 can be formed using semiconductor doping and diffusion techniques. In an example suitable for a 50 volt device, semiconductor region 14 can comprise an N-type conductivity and a dopant concentration of about 1.0x10¹⁶ atoms/cm³ to about 5.0x10¹⁷ atoms/cm³ and can have a thickness from about 3 microns to about 5 microns. The dopant concentration and thickness of semiconductor region 14 can be increased or decreased depending on the desired drain-to-source breakdown voltage (BV_{DSS}) rating of semiconductor device 10. In some examples, semiconductor region 14 can comprise a graded dopant profile. In an alternate example, the conductivity type of substrate 12 can be opposite to the conductivity type of semiconductor region 14 to form, for example, an IGBT semiconductor device.

Shield dielectric 24 can be one or more dielectric or insulative materials. In some examples, shield dielectric 24 can be about a 0.1 micron to about 1.5 microns thermal oxide layer. In some examples, shield dielectric 24 can be multiple layers of similar or different materials, such as thermal and deposited dielectric or insulative materials. The thickness of the shield dielectrics will vary with the required BV_{DSS} of the device, with higher BV_{DSS} requiring thicker layers. In accordance with some examples, upper trench dielectric 240 is thicker than shield dielectric 24 and inter-electrode dielectric 27. Upper trench dielectric 240 can be one more or more dielectric or insulative materials. In some examples, upper trench dielectric 240 can be about a 0.2 micron to about 2 microns thermal oxide layer. In some examples, upper trench dielectric 240 can be multiple layers of similar or different materials, such as thermal and deposited dielectric or insulative materials.

Gate dielectric 26 and inter-electrode dielectric 27 can comprise oxides, nitrides, tantalum pentoxide, titanium dioxide, barium strontium titanate, high k dielectric materials, combinations thereof, or other related or equivalent materials known by one of ordinary skill in the art. In some examples, gate dielectric 26 and inter-electrode dielectric 27 can be silicon oxide. In some examples, gate dielectric 26 can have a thickness from about 0.02 microns to about 0.1 microns, and inter-electrode dielectric 27 can have a thickness that is greater than that of gate dielectric 26. In some examples, dielectric 24 can have a greater thickness than gate dielectric 26 and inter-electrode dielectric 27. In accordance with some examples, upper trench dielectric 240 is thicker than shield dielectric 24 and inter-electrode dielectric 27.

In some examples, gate electrodes 28 and shield electrodes 21 comprise a doped polycrystalline semiconductor material, such as doped polysilicon. In some examples, N-type conductivity dopant materials can be used to dope the polysilicon. In some examples, metals, silicides, or other conductors can be included as part of gate electrode 28 or shield electrodes 21

As further illustrated in FIGS. 4 and 5, semiconductor device 10 comprises a body region 31 extending inward from major surface 18 into region of semiconductor material 11 (for example, extending inward into semiconductor region 14) adjacent to active trenches 22A and active trenches 22B. Body region 31 can also comprise or be referred to as a doped region or a base region. Body region 31 can have a conductivity type that is opposite to the conductivity type of semiconductor region 14. For example, when semiconductor region 14 comprises N-type conductivity, body region 31 comprises P-type conductivity. Body region 31 comprises a dopant concentration suitable for forming inversion layers that operate as channel regions for semiconductor device 10. In some examples, body region 31 can extend from major surface 18 to a depth from about 0.3 microns to about 1.5 micron. Body region 31 can be formed using doping techniques, such as ion implantation and anneal techniques. In some examples, body region 31 is a single continuous and interconnected region. In other examples, body region 31 can be a plurality of regions including separated regions.

Semiconductor device 10 can further comprise doped regions 33 within body region 31 in active mesa region 16A. In some examples, doped regions 33 can be optionally included within body region 31 in active mesa region 16A and a portion of intersection mesa region 16C proximate to active trench 22A. In some examples, doped regions 33 are not included proximate coupling trench 22C. In some examples, doped regions 33 are not included in body region 31 in termination mesa regions 16B so that termination mesa region 16B is devoid of doped regions 33. Doped regions 33 may also be referred to as source regions, current carrying regions, or current conducting regions. Doped regions 33 comprise an N-type conductivity when body region 31 comprises a P-type conductivity and can be formed using, for example, a phosphorous or arsenic dopant source. In some examples, an ion implant doping process can be used to form doped regions 33 within body region 31. Doped regions 33 can extend from major surface 18 to a depth for example, from about 0.2 microns to about 0.5 microns.

In some examples, semiconductor device 10 further comprises interlayer dielectric (ILD) 41 above active gate electrode 28A, above coupling gate electrode 28B, and above intersecting gate electrode 28C. In some examples, interlayer dielectric 41comprises silicon oxides, such as doped or undoped deposited silicon oxides. In some examples, interlayer dielectric 41 can include one layer of deposited silicon oxide doped with phosphorous or boron and phosphorous and one layer of undoped oxide. In some examples, interlayer dielectric 41 can have a thickness from about 0.25 microns to about 1.0 microns. In some examples, interlayer dielectric 41 can be planarized to provide a more uniform surface topography, which improves manufacturability.

In some examples, semiconductor device 10 further comprises body contact regions 36 within body region 31. Body contact regions 36 also can be referred to as doped regions, enhancement regions, or contact regions. In some examples, body contact region 36 can comprise P-type conductivity and are configured to provide a lower contact resistance to body region 31. Ion implantation (for example, using boron) and anneal techniques can be used to form body contact regions 36.

In some examples, semiconductor device 10 further comprises conductive regions 43, which are configured to provide electrical contact to doped regions 33 and body region 31 through body contact regions 36. Active gate electrodes 28A, coupling gate electrodes 28B, and intersecting gate electrode 28C can be connected to one or more gate contact trenches 280 and active shield electrodes 21A, coupling shield electrodes 21B, and intersecting shield electrode 21C can be connected to one or more shield contact trenches 210. In some examples, conductive regions 43 comprise conductive plugs or plug structures. In some examples, conductive regions 43 can include a conductive barrier structure or liner and a conductive fill material. In some examples, the barrier structure can include a metal/metal-nitride configuration, such as titanium/titanium-nitride or other related or equivalent materials as known by one of ordinary skill in the art. In other examples, the barrier structure can further include a metal-silicide structure. In some examples, the conductive fill material includes tungsten. In some examples, conductive regions 43 can be planarized to provide a more uniform surface topography.

In some examples, conductors 44A and 44B (shown in FIG. 1) can be formed adjacent to major surface 18, and conductor 46 can be formed adjacent to major surface 19. Conductors 44A and 44B can also be referred to as a top metal or a top conductor, and conductor 46 can also be referred to as a bottom conductor or a back metal. Conductors 44A, 44B, and 46 can be configured to provide electrical connection between the individual cells of semiconductor device 10 and a next level of assembly. In some examples, conductors 44A and 44B comprise titanium/titanium-nitride/aluminum-copper or other related or equivalent materials known by one of ordinary skill in the art and is configured as a source electrode or terminal. In some examples, conductor 46 comprises a solderable metal structure such as titanium-nickel-silver, chromium-nickel-gold, or other related or equivalent materials known by one of ordinary skill in the art and is configured as a drain electrode or terminal. In some examples, a further passivation layer (not shown) can be formed adjacent to conductors 44A and 44B. In some examples, shield electrodes 21 can be connected to conductor 44A so that shield electrodes 21 are configured to be at the same potential as doped regions 33 when semiconductor device 10 is in use. In other examples, shield electrodes 21 can be configured to be independently biased or coupled in part to gate contact trenches 280.

In an example, the operation of semiconductor device 10 can proceed as follows. If conductor 44A and shield electrodes 21 are operating at a potential V_{S} of zero volts, gate electrodes 28 would receive a control voltage V_{G} of 10 volts, which is greater than the conduction threshold of semiconductor device 10 and drain electrode (or output terminal) 46 would operate at a drain potential V_{D} of less than 2.0 volts. The values of V_{G} and V_{S} would cause body region 31 to invert adjacent gate electrodes 28 to form channel regions, which would electrically connect doped regions 33 to semiconductor region 14 in active mesa regions 16A. A device current I_{DS} would flow from conductor 46 and would be routed through semiconductor region 14, the channel regions, and doped regions 33 to conductor 44B. In some examples, I_{DS} is on the order of 10.0 amperes. To switch semiconductor device 10 to the off state, a control voltage V_{G} that is less than the conduction threshold of semiconductor is applied. Such a control voltage would remove the channel regions and I_{DS} would no longer flow through semiconductor device 10. In accordance with the present description the configuration of semiconductor device 10 as described herein achieves improved UIS performance due to the structural attributes of cell topography 100 including coupling trench 22C, which reduces shield resistance at the outer edge of semiconductor device 10. In addition, corner portion 22CA of coupling trench 22 was found through experimentation to provide improved BV_{DSS} performance through charge balance techniques.

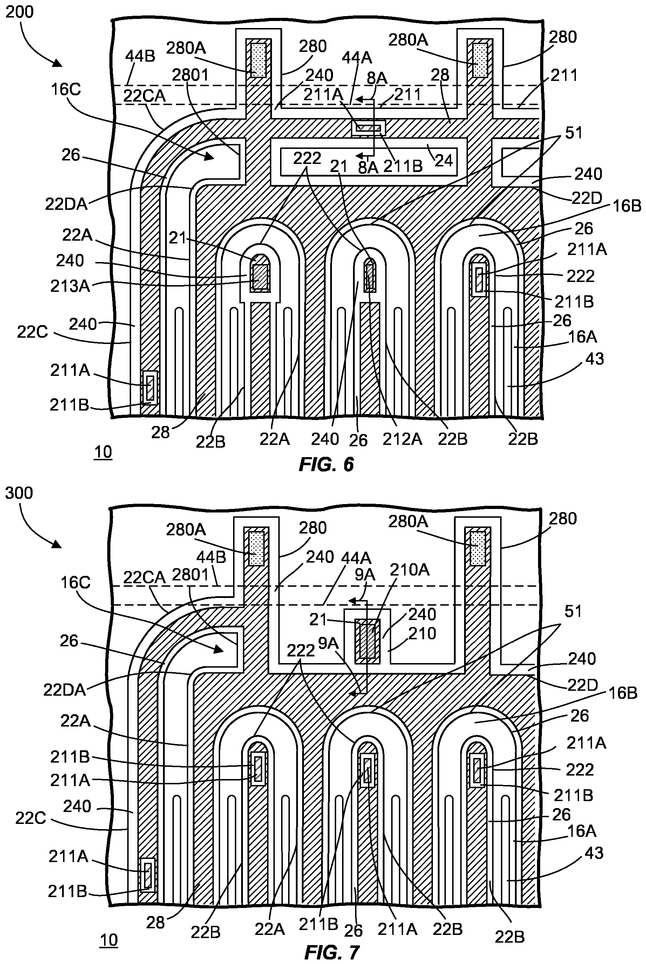

FIG. 6 illustrates a partial top plan view of an example cell topography 200 of a semiconductor device, such as semiconductor device 10 in accordance with the present description. In the present example, FIG. 6 illustrates an upper left portion of cell topography 200. Cell topography 200 of FIG. 6 has some similarity in construction to cell topography 100 of FIG. 1 and such similarity will not be repeated here. In the present example, shield contact trench 211 extends between a pair of gate contact trenches 280 and shield contact via 211A extends through gate electrode 28 to contact shield electrode 21 below gate electrode 28. Shield contact trench 211 is generally perpendicular to gate contact trenches 280 and is generally aligned with corner portion 22CA of coupling trench 22C. In the present example, shield contact via dielectric 211B insulates shield contact via 211A from gate electrode 28. In some examples, portions of gate electrode 28 extend above and below shield contact via dielectric 211B so that gate electrode 28 is continuous and uninterrupted in shield contact trench 211.

In some examples, the only shield contact trenches 211 or shield contact vias 211A in cell topography 200 and semiconductor device 10 are those shield contact trenches 211 or shield contact vias 211A that are external to or outside the boundary defined by top termination trench 22D and bottom termination trench 22D'. In this way, gate electrode 28 can be a continuous or uninterrupted structure internal to or inside the boundary defined by top termination trench 22D and bottom termination trench 22D'. In addition, contact to shield contact vias 211A can be facilitated to with conductor 44A.

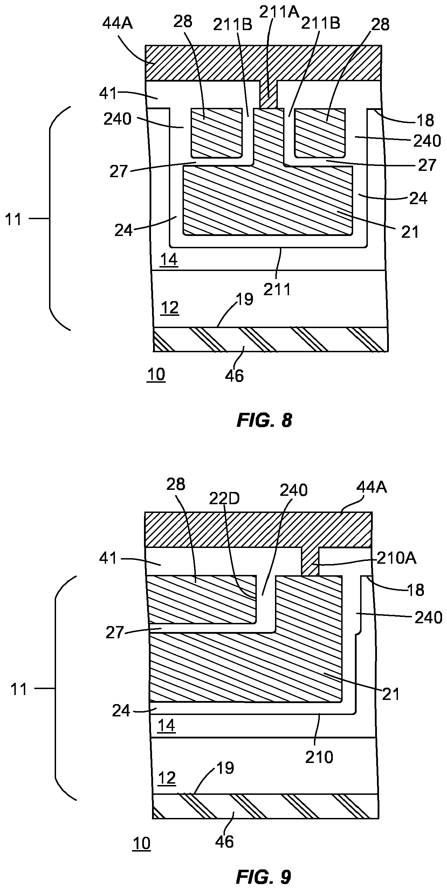

In some examples, cell topography 200 includes one or more shield contact vias in the active area or with coupling trench 22C. In some examples, cell topography 200 can further comprise a shield contact via 211A within coupling trench 22C or within tip region 222 of one or more of active trenches 22B (or active trench 22A as shown in FIG. 8), which can be insulated from gate electrode 28 by shield contact via dielectric 211B. Other types of shield contacts can be used, such as shield contact via 213A within tip region 222 of one or more active trenches 22B (or active trench 22A as shown in FIG. 8). In the present example, shield contact via 213A can be insulated from gate electrode 28 by thicker shield dielectric 24. The combination of shield contact via 213A and shield dielectric 24 can provide a flared-out shield contact via structure where tip region 222 is wider than the rest of active trench 22B. In some examples, a shield contact via 212A can be placed within a tip region of one or more of active trenches 22B (or active trench 22A as shown in FIG. 8). In the present example, shield contact via 212A can be insulated from gate electrode 28 by shield dielectric 24. Shield contact via 212A is narrower than shield contact via 213A so that the corresponding tip region 222 has the same width at the rest of active trench 22B. It is understood that any of the shield contact vias described herein can be used with any of the cell topographies described herein in any combination depending on desired device characteristics. In some examples, shield contact vias 211A, 212A, and 213A are coupled to conductor 44A. Using additional shield contact vias as described herein further reduces shield resistance in semiconductor device 10.

FIG. 7 illustrates a partial top plan view of an example cell topography 300 of a semiconductor device, such as semiconductor device 10 in accordance with the present description. In the present example, FIG. 7 illustrates an upper left portion of cell topography 300. Cell topography 300 of FIG. 7 has some similarity in construction to cell topography 100 of FIG. 1 and cell topography 200 of FIG. 6 and such similarity will not be repeated here. In the present example, cell topography 300 includes one or more shield contact vias in the active area or with coupling trench 22C. For example, cell topography 300 includes one or more shield contact vias 211A placed in tip regions 222 of active trenches 22B or coupling trench 22C, which further reduces shield resistance in semiconductor device 10.

FIG. 8 illustrates a partial cross-sectional view of an example shield contact trench 211 taken along reference line 8A-8A of FIG. 6. In the present example, a portion of shield electrode 21 is provided proximate to top side 18 of region of semiconductor material 11 between portions of gate electrode 28. Shield contact via dielectric 211B insulates that portion of shield electrode 21 from the portions of gate electrode 28. In some examples, shield contact dielectric 211B can be similar to inter-electrode dielectric 27. In some examples, shield contact via 211A extends through ILD 41 to couple to shield electrode 21. In other examples, shield contact via 211A can extend between the portions of gate electrode 28 and can couple to shield electrode 21 below the bottom side of gate electrode 28. In the present example, shield contact trench 211 is external to terminal trench 22D and is outside of the active area of semiconductor device 10.

FIG. 9 illustrates a partial cross-sectional view of an example shield contact trench 210 taken along reference line 9A-9A of FIG. 7. In the present example, a portion of shield electrode 21 is proximate to top side 18 of region of semiconductor material 11 external to, in this example, top termination trench 22D. In some examples, shield contact via 210A extends through ILD 41 to couple to shield electrode 21. In other examples, shield contact via 210A can extend through upper trench dielectric 240 and can couple to shield electrode 21 below the bottom side of gate electrode 28. In the present example, shield contact via 210A is external to terminal trench 22D and is outside of the active area of semiconductor device 10.

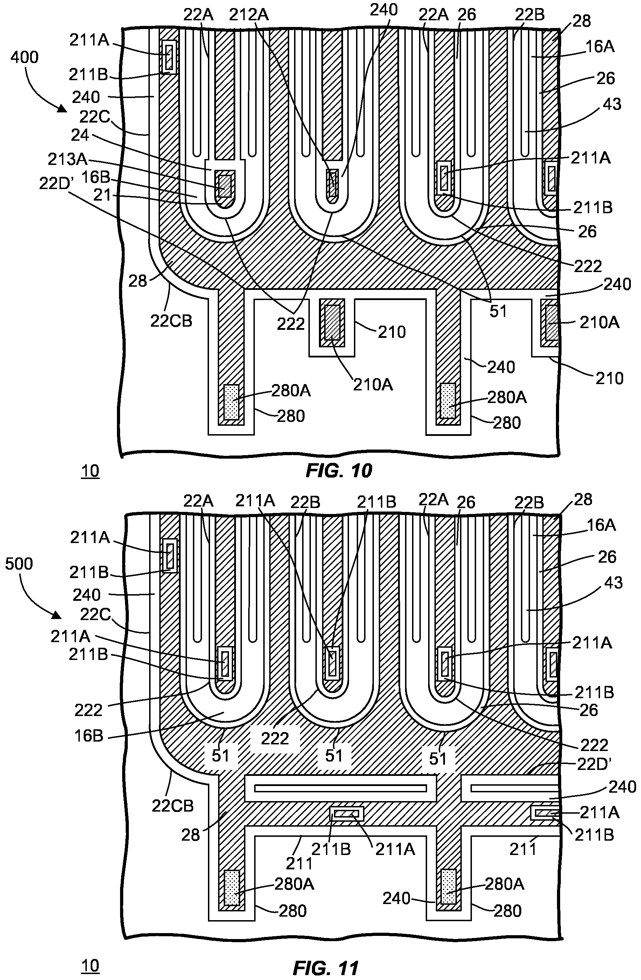

FIG. 10 illustrates a partial top plan view of an example cell topography 400 of a semiconductor device, such as semiconductor device 10 in accordance with the present description. In the present example, FIG. 10 illustrates a lower left portion of cell topography 400. Cell topography 400 of FIG. 10 has some similarity in construction to cell topography 100 of FIG. 1 and cell topography 200 of FIG. 6 and such similarity will not be repeated here. In the present example, cell topography 400 includes one or more shield contact vias in the active area or with coupling trench 22C. For example, cell topography 400 includes one or more shield contact vias in the active area of cell topography or coupling trench 22C. In some examples, shield contact vias 211A, 212A, or 213A as described previously can be within actives trenches 22A or coupling trench 22C, which further reduces the shield resistance in semiconductor device 10.

FIG. 11 illustrates a partial top plan view of an example cell topography 500 of a semiconductor device, such as semiconductor device 10 in accordance with the present description. In the present example, FIG. 11 illustrates a lower left portion of cell topography 500. Cell topography 500 of FIG. 9 has some similarity in construction to cell topography 100 of FIG. 1, cell topography 200 of FIG. 6, and cell topography 300 of FIG. 7, and such similarity will not be repeated here. In the present example, cell topography 500 includes one or more shield contact vias in the active area or within coupling trench 22C. In some examples, shield contact vias 211A as described previously can be within actives trenches 22A or coupling trench 22C, which further reduces the shield resistance in semiconductor device 10. Similar to cell topography 200, cell topography 500 uses shield contact trench 211, which extends between a pair of gate contact trenches 280, and shield contact via 211A, which extends through gate electrode 28 to contact shield electrode 21 below gate electrode 28. Shield contact trench 211 is generally perpendicular to gate contact trenches 280.

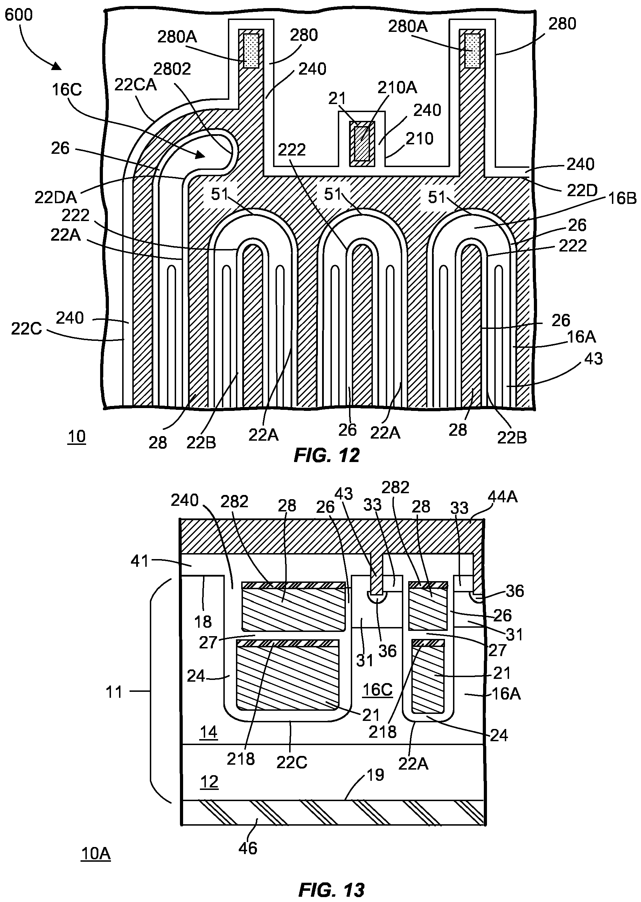

FIG. 12 illustrates a partial top plan view of an example cell topography 600 of a semiconductor device, such as semiconductor device 10 in accordance with the present description. In the present example, FIG. 12 illustrates an upper left portion of cell topography 600. Cell topography 600 of FIG. 12 has some similarity in construction to cell topography 100 of FIG. 1, and such similarity will not be repeated here. In the present example, sidewall 2802 of gate contact trench 280 coupled to coupling trench 22C comprises a curved, arched, or non-linear shape, which is configured in some examples to control electric field spread in semiconductor device 10 to improve BV_{DSS} performance.

FIG. 13 illustrates a partial cross-sectional view of an example semiconductor device 10A in accordance with the present description. Semiconductor device 10A of FIG. 13 has some similarity in construction to semiconductor device 10 of FIG. 4, and such similarity will not be repeated here. In the present example, semiconductor device 10A comprises a gate silicide 282 over gate electrode 28. In some examples, gate silicide 282 can comprise cobalt silicide or other silicide materials as known to one of ordinary skill in the art. In the present example, gate silicide 282 can be used to reduce gate resistance in embodiments where additional shield contact vias are used with coupling trench 22C in accordance with the present description. In other embodiments, shield silicide 218 can also be provided over shield electrode 21 to further reduce shield resistance. Shield silicide 218 can comprise cobalt silicide or other materials as known to one of ordinary skill in the art.

In general, the present examples relate to semiconductor device structures and methods of making semiconductor devices, such as shielded-gate trench MOSFET devices, having improved manufacturability and performance. In some examples, structures and methods are described that address the BV_{DSS} performance issue in GTT structures that use an arch-termination design. Examples include a GTT type cell topography that have interleaved or offset comb active trenches, an arch-termination design, and a coupling trench. The coupling trench connects to one side of the cell topography and includes a wrap-around top trench that connects to a gate contact trench at an opposite side of the cell topography. The coupling trench can also form an additional termination trench that facilitates design flexibility. In some examples, gate connections can be provided on opposing sides of the cell topography to reduce gate resistance.

In some examples, shield electrode connections are also facilitated on opposing of the cell topography, which reduces shield resistance. In some examples, for a given cell topography length, the present structures reduce shield resistance by approximately one half. Examples are also described that provide additional shield contacts within the cell topography to further improve shield resistance performance. The cell topography also facilitates gate connections from one side or an opposing side or both. In some examples, a gate silicide structure can be used to offset any increase in gate resistance.

From all the foregoing, one of ordinary skill in the can determine that a semiconductor device can include a region of semiconductor material, a first termination trench within the region of semiconductor material and a second termination trench within the region of semiconductor and coupled to the first termination trench, wherein the first termination trench and the second termination trench define an active area. Active trenches are within the active area and a coupling trench is within the region of semiconductor material and external to the active area. A shield conductor is within the coupling trench, the active trenches, the first termination trench, and the second termination trench. A gate conductor is within the coupling trench, the active trenches, the first termination trench; and the second termination trench. A shield contact trench is coupled to the first termination trench and a shield contact via within the shield contact trench, external to the active area, and coupled to the shield conductor. A gate contact trench is coupled to the first termination trench and a gate contact via within the gate contact trench and coupled to the gate conductor. The gate conductor is a continuous and uninterrupted conductor within the active area and the coupling trench couples the active area to the gate contact trench. In another example, the active area is devoid of any shield contact vias.

From all the foregoing, one of ordinary skill in the art can determine that a method of manufacturing a semiconductor device includes providing a region of semiconductor material including a top side, an active mesa region, a termination mesa region, an intersection mesa region, a first edge region at the top side, a second edge region at the top side opposite to the first edge region, and a third edge region at the top side extending between the first edge region and the second edge region. The method includes providing trench regions extending into the region of semiconductor material including a first termination trench within the first edge region, a second termination trench within the second edge region and coupled to the first termination trench, a first active trench extending from the first termination trench towards the second termination trench and terminating with a first tip region that is separated from the second termination trench by the termination mesa region, a second active trench extending from the second termination trench towards the first termination trench, separated from the first active trench by the active mesa region, and terminating with a second tip region that is separated from the first termination trench by the termination mesa region, a first gate contact trench coupled to the first termination trench within the first edge region, and a coupling trench within the third edge region coupled to the second termination trench and comprising a corner portion that couples the coupling trench to the first gate contact trench, the corner portion separated from the first termination trench by the intersection mesa region. The method includes providing a shield electrode within the coupling trench. The method includes providing a shield dielectric within the coupling trench insulating the shield electrode from the region of semiconductor material. The method includes providing a gate electrode within the coupling trench. The method includes providing a gate dielectric within the coupling trench insulating the gate electrode from the region of semiconductor material. The method includes providing an inter-electrode dielectric insulating the gate electrode from the shield electrode.

In another example, the method can include providing a second gate contact trench coupled to the second termination trench within the second edge region and laterally offset with respect to the first gate contact trench in a top plan view. In a further example, the method can include providing a first shield contact trench coupled to the first termination trench within the first edge region. In a still further example, the method can include providing a second shield contact trench coupled to the second termination trench within the second edge region.

From all the foregoing, one of ordinary skill in the can determine that in an example structure, the second gate contact trench can be laterally offset with respect to the first gate contact trench in a top plan view. In another example, the structure can comprise a second shield contact trench external to the second termination trench within the second edge region, laterally offset with respect to the first shield contact trench in a top plan view and coupled to the shield electrode. In a further example, the corner portion can comprise an arch shape in a top plan view. In a still further example, the sidewall can comprise a linear shape in a top plan view. In another example, the sidewall can comprise a non-linear shape in a top plan view.

In summary, structures and methods have been described for a semiconductor device having improved manufacturability and performance. More particularly, structures and methods that address the BV_{DSS} performance issue in GTT structures that use a connected trench termination design. Examples include a GTT type cell topography that have interleaved or offset comb active trenches, an arch-termination design, and a coupling trench. The coupling trench connects to one side of the cell topography and includes a wrap-around top trench that connects to a gate contact trench at an opposite side of the cell topography. The coupling trench can also form an additional termination trench that facilitates design flexibility. In some examples, gate connections can be provided on opposing sides of the cell topography to reduce gate resistance.

In some examples, shield electrode connections are also facilitated on opposing edges or sides of the cell topography, which reduces shield resistance. In some examples, for a given cell topography length, the present structures reduce shield resistance by approximately one half. Compared to previous cell topographies, the shield connections in the present description are provided without interrupting the connections between the active gate trenches and the gate contacts, which are outside of the area of the topography where source metal contact is made. In addition, the present description provides shield contacts inside the area of the topography where source metal contact is made. Examples are also described that provide additional shield contacts within the cell topography to further improve shield resistance performance. The cell topography also facilitates gate connections from one side or an opposing side or both. In some examples, a gate silicide structure can be used to offset any increase in gate resistance.

It is understood that the different examples described herein can be combined with any of the other examples described herein to obtain different embodiments.

While the subject matter of the invention is described with specific preferred examples, the foregoing drawings and descriptions thereof depict only typical examples of the subject matter and are not therefore to be considered limiting of its scope. It is evident that many alternatives and variations will be apparent to those skilled in the art. For example, the conductivity types of the various regions can be reversed. Also, other IV-IV semiconductor materials besides SiC, such as SiGe or SiGeC can be used. Additionally, other compound semiconductor materials can be used. In addition, the structures and methods described herein can be used for higher voltage devices (for example, greater than 100 volts) or lower voltage devices (for example, less than 30 volts). Still further, the coupling trench can be connected to a shield contact trench instead of or in addition to connecting to a gate contact trench.

As the claims hereinafter reflect, inventive aspects may lie in less than all features of a single foregoing disclosed example. Thus, the hereinafter expressed claims are hereby expressly incorporated into this Description, with each claim standing on its own as a separate example of the invention. Furthermore, while some examples described herein include some, but not other features included in other examples, combinations of features of different examples are meant to be within the scope of the invention and meant to form different examples as would be understood by those skilled in the art.

## Claims

1. A semiconductor device, comprising:
a region of semiconductor material comprising:
a top side;
an active mesa region;
a termination mesa region;
an intersection mesa region;
a first edge region at the top side;
a second edge region at the top side opposite to the first edge region; and
a third edge region at the top side extending between the first edge region and the second edge region;
a first termination trench within the first edge region;
a second termination trench within the second edge region and coupled to the first termination trench;
a first active trench extending from the first termination trench towards the second termination trench and terminating with a first tip region that is separated from the second termination trench by the termination mesa region;
a second active trench extending from the second termination trench towards the first termination trench, separated from the first active trench by the active mesa region, and terminating with a second tip region that is separated from the first termination trench by the termination mesa region;
a first gate contact trench coupled to the first termination trench within the first edge region;
a coupling trench within the third edge region coupled to the second termination trench and comprising a corner portion that couples the coupling trench to the first gate contact trench, the corner portion separated from the first termination trench by the intersection mesa region;
a shield electrode within the coupling trench;
a shield dielectric within the coupling trench insulating the shield electrode from the region of semiconductor material;
a gate electrode within the coupling trench;
a gate dielectric within the coupling trench insulating the gate electrode from the region of semiconductor material; and
an inter-electrode dielectric insulating the gate electrode from the shield electrode.

2. The semiconductor device of claim 1, further comprising:
a second gate contact trench coupled to the second termination trench within the second edge region; and
a first shield contact trench external to the first termination trench within the first edge region and coupled to the shield electrode.

3. The semiconductor device of claim 2, wherein:
the first shield contact trench is parallel to the first gate contact trench.

4. The semiconductor device of claim 2, wherein:
the first shield contact trench is perpendicular to the first gate contact trench and intersects the first gate contact trench.

5. The semiconductor device of claim 1, further comprising:
a shield contact via within the coupling trench; and
a gate silicide on the gate electrode in the coupling trench.

6. The semiconductor device of claim 1, wherein:
the intersection mesa region comprises an intersection mesa width at the first gate contact trench between the corner portion of the coupling trench and the first termination trench; and
the intersection mesa width is greater than about 600 nanometers.

7. The semiconductor device of claim 1, wherein:
the first gate contact trench comprises a sidewall that extends between the corner portion of the coupling trench and the first termination trench.

8. The semiconductor device of claim 1, wherein:
the first termination trench comprises an arched termination structure proximate to the first tip region of the first active trench.

9. A semiconductor device, comprising:
a region of semiconductor material comprising:
a top side;
an active mesa region;
a termination mesa region;
an intersection mesa region;
a first edge region at the top side;
a second edge region at the top side opposite to the first edge region; and
a third edge region at the top side extending between the first edge region and the second edge region;
a first termination trench within the first edge region;
a second termination trench within the second edge region and coupled to the first termination trench;
first active trenches extending from the first termination trench towards the second termination trench and terminating with first tip regions that are separated from the second termination trench by the termination mesa region;
second active trenches extending from the second termination trench towards the first termination trench, interleaved with the first active trenches, separated from the first active trenches by the active mesa region, and terminating with second tip regions that are separated from the first termination trench by the termination mesa region;
a first gate contact trench coupled to the first termination trench within the first edge region;
a coupling trench within the third edge region coupled to the second termination trench and comprising a corner portion that couples the coupling trench to the first gate contact trench, the corner portion separated from the first termination trench by the intersection mesa region;
a shield electrode in the coupling trench;
a shield dielectric in the coupling trench insulating the shield electrode from the region of semiconductor material;
a gate electrode in the coupling trench and comprising a first side adjacent to the termination mesa region and a second side opposite to the first side;
a gate dielectric in the coupling trench insulating the first side of the gate electrode from the intersection mesa region, wherein the shield dielectric insulates the second side of the gate electrode from the region of semiconductor material; and
an inter-electrode dielectric insulating the gate electrode from the shield electrode.

10. The semiconductor device of claim 9, wherein:
the shield electrode and the gate electrode are within the first termination trench, the second termination trench, the first active trenches, and the second active trenches.

11. The semiconductor device of claim 9, further comprising:
a second gate contact trench coupled to the second termination trench within the second edge region and laterally offset with respect to the first gate contact trench in a top plan view; and
a first shield contact trench coupled to the first termination trench within the first edge region.

12. The semiconductor device of claim 9, wherein:
the first termination trench comprises first arched termination structures proximate to the first tip regions of the first active trenches;
the second termination trench comprises second arched termination structures proximate to the second tip regions of the second active trenches;
the first tip regions and the second tip regions comprise outward rounded arches in a top plan view;
the first arched termination structures and the second arched termination structures comprise inward rounded arches in the top plan view; and
the first arched termination structures are laterally offset with respect to the second arched termination structures in the top plan view.

13. The semiconductor device of claim 9, wherein:
the intersection mesa region comprises an intersection mesa width at the first gate contact trench between the corner portion of the coupling trench and the first termination trench;
the intersection mesa width is greater than about 800 nanometers;
the first gate contact trench comprises a sidewall that extends between the corner portion of the coupling trench and the first termination trench; and
the sidewall comprises a linear shape in a top plan view.

14. A method of providing a semiconductor device, comprising:
providing a region of semiconductor material;
providing a first termination trench within the region of semiconductor material;
providing a second termination trench within the region of semiconductor and coupled to the first termination trench, wherein the first termination trench and the second termination trench provide an active area;
providing active trenches within the active area;
providing a coupling trench within the region of semiconductor material and external to the active area;
providing a shield conductor within the coupling trench, the active trenches, the first termination trench, and the second termination trench;
providing a gate conductor within the coupling trench, the active trenches, the first termination trench; and the second termination trench;
providing a shield contact trench coupled to the first termination trench;
providing a shield contact via within the shield contact trench, external to the active area, and coupled to the shield conductor;
providing a gate contact trench coupled to the first termination trench; and
providing a gate contact via within the gate contact trench and coupled to the gate conductor;
wherein:
the gate conductor is a continuous and uninterrupted conductor within the active area; and
the coupling trench couples the active area to the gate contact trench.

15. The method of claim 14, wherein:
the active area is devoid of any shield contact vias.
